# EUROPEAN PATENT APPLICATION

(11) **EP 4 148 768 A1**
(43) Date of publication of application: **15.03.2023**
(21) Application number: 21800450.5
(22) Date of filing: 29.03.2021
(51) Int. Cl.: H01L 21/205, C23C 16/455

(54) **DEPOSITION DEVICE AND PLATE**

(30) Priority: 08.05.2020 JP 2020082627
(71) Applicant: NuFlare Technology, Inc., Yokohama-shi, Kanagawa 235-8522 (JP)
(72) Inventor: DAIGO, Yoshiaki, Yokohama-shi, Kanagawa 235-8522 (JP); UMETSU, Takuto, Yokohama-shi, Kanagawa 235-8522 (JP); ISHIGURO, Akio, Yokohama-shi, Kanagawa 235-8522 (JP)
(74) Representative: Hoffmann Eitle
(86) International application number: PCT/JP2021/013327
(87) International publication number: WO 2021/225047

(57) **Abstract**

[Problem] To provide a film forming apparatus and a plate that enable the concentration or flow rate of a process gas supplied in a plane of a substrate to be controlled in the radial direction.

[Solution] A film forming apparatus according to the present embodiment comprises: a film formation chamber capable of accommodating a substrate; a gas supplier including a plurality of nozzles provided in an upper portion of the film formation chamber to supply a process gas onto a film formation face of the substrate, and a cooling part configured to suppress a temperature increase of the process gas; a heater configured to heat the substrate to 1500°C or higher; and a plate opposed to a bottom face of the gas supplier, where first opening parts of the nozzles are formed, in the film formation chamber, and arranged away from the bottom face, in which the plate includes a plurality of second opening parts having a smaller diameter than the first opening parts, and arranged substantially uniformly in a plane of the plate, and a partition protruded on an opposed face to the gas supplier and separating the plane of the plate into a plurality of regions.

## Description

### Field

Embodiments of the present invention relate to a film forming apparatus and a plate.

### Background

A film forming apparatus used in an epitaxial growth method for a SiC film or the like needs to heat a substrate at high temperatures between 1500°C and 1700°C. Therefore, for example, a gas supplier provided in an upper portion of a film formation chamber is also expected to be exposed to high temperatures due to radiation from a heater for heating the substrate, and the like. When a source gas and a doping gas circulate by convection near the gas supplier and are heated, deposits including a material and a dopant adversely adhere to the surface of the gas supplier. These deposits having adhered to the gas supplier become particles to fall on the substrate and lead to device malfunction. There is also a problem that the doping concentration of the SiC film changes with time due to exhaust of a dopant gas from the deposits having adhered to the gas supplier (a memory effect).

### Citation List

### Patent Literatures

Patent Literature 1: Japanese Patent Application Laid-open No. 2018-082063
Patent Literature 2: Japanese Patent Application Laid-open No. 2018-082064

### Summary

### Technical Problem

To provide a film forming apparatus and a plate that enable the concentration or flow rate of a process gas supplied in a plane of a substrate to be controlled in the radial direction.

### Solution to Problem

A film forming apparatus according to the present embodiment comprises: a film formation chamber capable of accommodating a substrate; a gas supplier including a plurality of nozzles provided in an upper portion of the film formation chamber to supply a process gas onto a film formation face of the substrate, and a cooling part configured to suppress a temperature increase of the process gas; a heater configured to heat the substrate to 1500°C or higher; and a plate opposed to a bottom face of the gas supplier, where first opening parts of the nozzles are formed, in the film formation chamber, and arranged away from the bottom face, in which the plate includes a plurality of second opening parts having a smaller diameter than the first opening parts, and arranged substantially uniformly in a plane of the plate, and a partition protruded on an opposed face to the gas supplier and separating the plane of the plate into a plurality of regions.

A plate according to the present embodiment is a plate opposed to a gas supplier configured to supply a gas onto a film formation face of a substrate in a film formation chamber, the plate being placed away from the gas supplier, the plate including: a plurality of second opening parts having a smaller diameter than first opening parts of nozzles provided on the gas supplier to supply the gas, the second opening parts being arranged substantially uniformly in a plane of the plate; and a partition protruded on an opposed face to the gas supplier.

### Brief Description of Drawings

[FIG. 1] FIG. 1 is a sectional view illustrating a configuration example of a film forming apparatus according to a first embodiment.
[FIG. 2] FIG. 2 is a sectional view illustrating a configuration example of a head part of a chamber.
[FIG. 3] FIG. 3 is a diagram illustrating an arrangement relation between a plate and first opening parts.
[FIG. 4] FIG. 4 is a sectional view along a line 4-4 in FIG. 3.
[FIG. 5] FIG. 5 is a side view of the plate.
[FIG. 6] FIG. 6 is a sectional view illustrating a configuration example of a gas supplier that includes nozzles each having a temperature measuring window attached thereto.
[FIG. 7] FIG. 7 is an enlarged view illustrating a gap between the gas supplier and the plate.
[FIG. 8A] FIG. 8A is a graph representing a film doping concentration distribution in the plane of a substrate.
[FIG. 8B] FIG. 8B is a graph representing a film doping concentration distribution in the plane of the substrate.
[FIG. 9A] FIG. 9A is a graph representing variations of the film thickness in the plane of the substrate.
[FIG. 9B] FIG. 9B is a graph representing variations of the film thickness in the plane of the substrate.
[FIG. 10] FIG. 10 is a diagram illustrating an arrangement relation between a plate and first opening parts according to a second embodiment.
[FIG. 11] FIG. 11 is a diagram illustrating a configuration example of a plate according to a third embodiment.
[FIG. 12] FIG. 12 is a sectional view along a line 12-12 in FIG. 11.
[FIG. 13] FIG. 13 is a perspective view illustrating a configuration example of a partition.
[FIG. 14] FIG. 14 is a perspective view illustrating a configuration example of a jig.
[FIG. 15] FIG. 15 is a perspective view illustrating a configuration example of a jig.
[FIG. 16] FIG. 16 is a diagram illustrating a configuration example of a plate according to a modification of the third embodiment.

### Description of Embodiments

Embodiments of the present invention will now be explained with reference to the drawings. The present invention is not limited to the embodiments. The drawings are schematic or conceptual and the ratios and the like among the respective constituent elements are not necessarily the same as those of actual products. In the present specification and the drawings, elements identical to those described in the foregoing drawings are denoted by like reference signs and detailed explanations thereof are omitted as appropriate.

### (First embodiment)

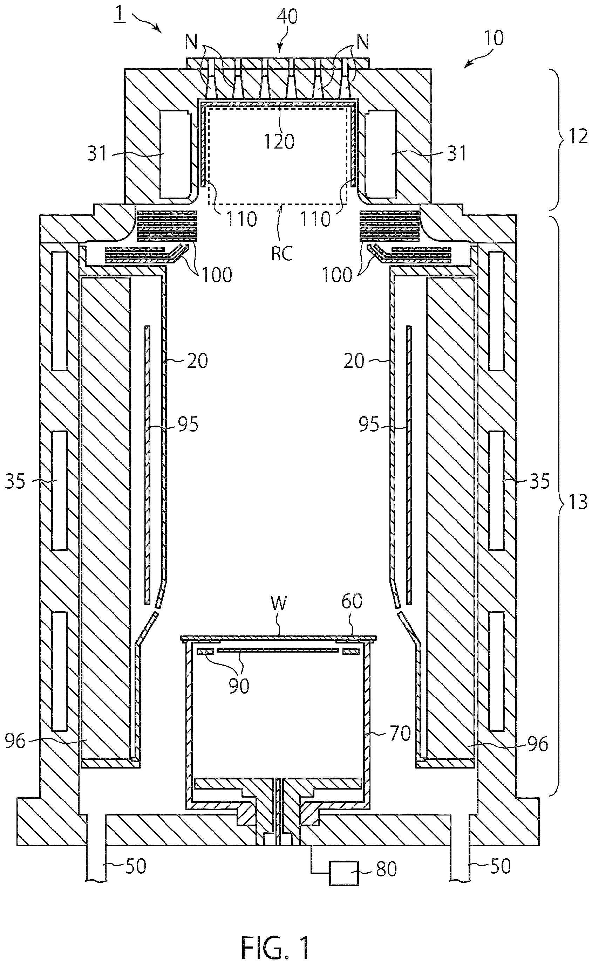

FIG. 1 is a sectional view illustrating a configuration example of a film forming apparatus 1 according to a first embodiment. The film forming apparatus 1 includes a chamber 10, a liner 20, cooling parts 31 and 35, a gas supplier 40, an exhaust part 50, a susceptor 60, a support 70, a rotation mechanism 80, a lower heater 90, an upper heater 95, a reflector 100, a liner 110, a plate 120, and a heat insulator 96.

The chamber 10 being a film formation chamber is capable of accommodating a substrate W and is, for example, made of stainless steel. The inner portion of the chamber 10 is depressurized by a vacuum pump (not illustrated). The chamber 10 includes a head part 12 and a body part 13. The gas supplier 40 and the cooling part 31 are provided in the head part 12. The temperature of a process gas including a source gas, a carrier gas, an assist gas, and a doping gas supplied from the gas supplier 40 is suppressed from increasing by the cooling part 31 in the inner portion of the head part 12 of the chamber 10. Therefore, the inner portion of the head part 12 of the chamber 10 is hereinafter referred to as "temperature increase suppression region Rc". The assist gas is a gas functioning to prevent overreaction of the source gas, and the like. For example, when Si-based gas is used as the source gas in formation of a SiC film, an effect of preventing clustering of Si in a gas phase and the like is obtained by addition of HCl as the assist gas.

The susceptor 60, the rotation mechanism 80, the lower heater 90, the upper heater 95, and the like are provided in the chamber 10 at the body part 13. The gas supplied from the gas supplier 40 is heated inside the body part 13 and reacts on the surface of the substrate W. Accordingly, a film is epitaxially grown on the substrate W. The film is, for example, a SiC film.

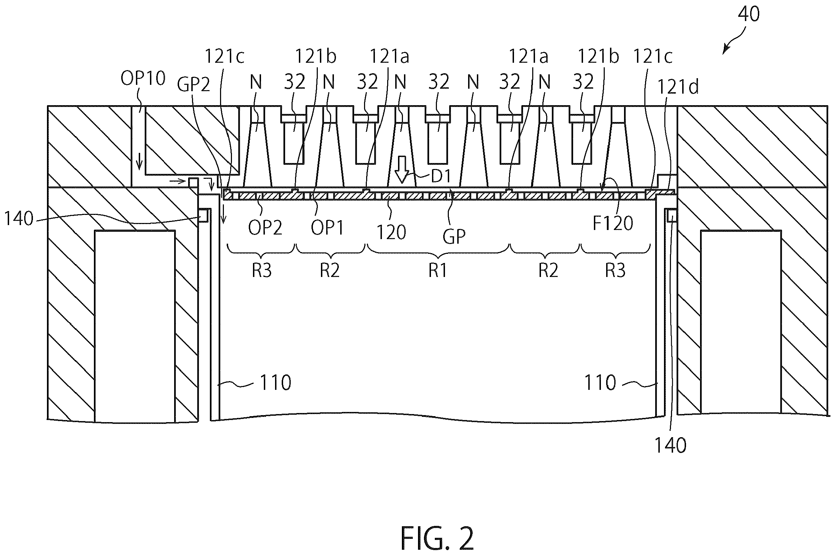

The internal diameter of the liner 110 included in the head part 12 of the chamber 10 is equal to or smaller than that of the liner 20 included in the body part 13. The liner 110 is a hollow cylindrical member that covers the inner wall of the head part 12 of the chamber 10 to suppress generation of deposits on the inner wall of the head part 12. A material being high in the infrared transmissivity, for example, quartz is used as a material of the liner 110. This configuration suppresses the liner 110 from being heated to high temperatures by radiation from the upper heater 95 and the lower heater 90 through the liner 20, the susceptor 60, and the substrate W. The liner 110 is placed so as not to scrape against the inner wall of the head part 12 even when thermally deformed. Accordingly, the outer wall surface of the liner 110 and the inner wall surface of the head part 12 are arranged away from each other, except a support (not illustrated in FIG. 1, a support 140 in FIG. 2) provided on the side of the inner wall of the head part 12 to support the liner 110.

The liner 20 is a hollow cylindrical member that covers the inner wall of the chamber 10 to suppress generation of deposits on the upper heater 95, the heat insulator 96, and the inner wall of the body part 13. The liner 20 is heated to high temperatures by radiation from the upper heater 95 and functions as a hot wall for heating the substrate W by radiation. A material having a high heat resistance is selected as a material of the liner 20 and, for example, carbon or carbon coated with SiC is used.

The cooling part 31 is provided in the head part 12 of the chamber 10 and is, for example, a flow path of a refrigerant (for example, water). With flowing of the refrigerant in the flow path, the cooling part 31 suppresses a temperature increase of the gas in the temperature increase suppression region Rc. As illustrated in FIG. 2 described later, a cooling part 32 is provided also around each of nozzles N of the gas supplier 40. This configuration can suppress a temperature increase of the gas to be supplied to the temperature increase suppression region Rc. In addition, the cooling part 31 prevents the head part 12 of the chamber 10 from being heated by radiation from the upper heater 95 and the lower heater 90.

The cooling part 35 is provided in the body part 13 of the chamber 10 and is, for example, a flow path of a refrigerant (for example, water) similarly to the cooling part 31. However, the cooling part 35 is not provided to cool a space in the body part 13 but is provided to prevent heat from the upper heater 95 and the lower heater 90 from heating the body part 13 of the chamber 10.

The gas supplier 40 is provided on the top face of the chamber 10, opposed to the surface of the substrate W and includes a plurality of nozzles N. The gas supplier 40 is provided above the lower heater 90 and the upper heater 95 and is located in an upper portion of the temperature increase suppression region Rc. The gas supplier 40 supplies the source gas (Si-based gas, C-based gas, or the like), the doping gas (nitrogen gas, aluminum-containing gas, or the like), the assist gas (HCl gas, or the like), and the carrier gas (hydrogen gas, argon gas, or the like) to the temperature increase suppression region Rc in the chamber 10 through the nozzles N.

The exhaust part 50 is provided on the bottom of the chamber 10 and exhausts the gas having been used in the film formation process to the outside of the chamber 10.

The susceptor 60 is an annular member on which the substrate W can be mounted and is, for example, made of carbon. The support 70 is a cylindrical member capable of supporting the susceptor 60 and is, for example, made of carbon similarly to the susceptor 60. The support 70 is connected to the rotation mechanism 80 and is configured to be rotatable by the rotation mechanism 80. The support 70 can rotate the substrate W with the susceptor 60. The susceptor 60 and the support 70 may be formed of a material having a resistance to high temperatures equal to or higher than 1500°C, such as SiC (silicon carbide), TaC (tantalum carbide), W (tungsten), or Mo (molybdenum) as well as carbon. Carbon coated with SiC or TaC may be used for the susceptor 60 and the support 70.

The lower heater 90 is placed below the susceptor 60 and the substrate W and inside the support 70. The lower heater 90 heats the substrate W from below through the susceptor 60. The upper heater 95 is placed along a side surface of the heat insulator 96 provided on an inner circumference of the body part 13 of the chamber 10 and heats the substrate W from above through the liner 20. The lower heater 90 and the upper heater 95 heat the substrate W to high temperatures equal to or higher than 1500°C while the rotation mechanism 80 rotates the substrate W, for example, at a rotational speed equal to or higher than 300 rpm. This operation enables the substrate W to be uniformly heated.

The reflector 100 is placed between the head part 12 and the body part 13 in the chamber 10 and is, for example, made of carbon. The reflector 100 reflects the heat from the lower heater 90 and the upper heater 95 downward. Accordingly, the temperature of the head part 12 is prevented from excessively increasing by the radiation from the lower heater 90 and the upper heater 95. The reflector 100 and the cooling part 31 function to cause the temperature in the temperature increase suppression region Rc to be lower than a reaction temperature of the source gas. The reflector 100 may be formed of a material having a resistance to high temperatures equal to or higher than 1500°C, such as SiC (silicon carbide), TaC (tantalum carbide), W (tungsten), or Mo (molybdenum) as well as carbon. Although the reflector 100 may be one thin plate, a configuration in which a plurality of thin plates are spaced at appropriate intervals is preferable to efficiently reflect the heat.

Configurations of the liner 110 and the plate 120 are explained with reference to FIG. 2.

FIG. 2 is a sectional view illustrating a configuration example of the head part 12 of the chamber 10. The gas supplier 40 includes the nozzles N. The nozzles N are provided to jet the source gas, the doping gas, the assist gas, and the carrier gas toward the surface of the substrate W mounted on the susceptor 60 in the chamber 10. The gas supplier 40 jets the gases including the source gas, the doping gas, the assist gas, and the carrier gas in a direction (that is, a substantially vertical direction) D1 substantially perpendicular to the surface of the substrate W. The nozzles N introduce the gases including the source gas, the doping gas, the assist gas, and the carrier gas from gas pipes (not illustrated) connected to the nozzles N to the temperature increase suppression region Rc. First opening parts OP1 of the nozzles N are located on the inner side of the chamber 10 and are openings of the nozzles N that jet the gases. The cooling part 32 is provided around each of the nozzles N of the gas supplier 40 and suppresses the temperatures of the gas supplier 40 and the head part 12 from excessively increasing.

The liner 110 is a hollow cylindrical member that covers the inner wall of the head part 12 in the chamber 10 to suppress generation of deposits on the inner wall of the head part 12. The liner 110 is supported by the support 140 provided on the side of the inner wall of the head part 12. A material being high in the infrared transmissivity, for example, quartz is used as a material of the liner 110. This configuration suppresses the liner 110 from being heated to high temperatures by the radiation from the upper heater 95 and the lower heater 90 through the liner 20, the susceptor 60, the substrate W, or the like. The liner 110 is placed not to be in contact with the inner wall of the head part 12 even when thermally deformed. Accordingly, the outer wall surface of the liner 110 is located away from the inner wall surface of the head part 12, except the support 140.

The plate 120 is provided below the gas supplier 40 and is arranged along the inner edge of the liner 110. The plate 120 has a substantially circular planar shape and is constituted of a material being high in the infrared transmissivity such as quartz. This configuration suppresses the plate 120 from being heated to high temperatures. The plate 120 is partially mounted on the liner 110 by a support 121d of the plate 120. A gap GP2 is provided between the plate 120 and the liner 110, except a contact part between the support 121d and the liner 110. The gap GP2 enables a purge gas from an opening part OP10 described later to flow along an inner circumferential side surface of the liner 110. This operation enables the source gas introduced from second opening parts OP2 described later into the temperature increase suppression region Rc to be prevented from easily reaching the liner 110 and suppresses generation of reaction by-products on the surface of the liner 110.

The plate 120 is placed at a location facing the first opening parts OP1 of the nozzles N of the gas supplier 40 in the chamber 10 and is arranged away from the bottom face of the gas supplier 40. The plate 120 is provided to cover the bottom face of the gas supplier 40, where the first opening parts OP1 are located. Meanwhile, there is a gap GP between the gas supplier 40 and the plate 120, and the plate 120 is not in direct contact with the gas supplier 40. This configuration prevents interference of the plate 120 with the bottom face of the gas supplier 40 even when the plate 120 is thermally deformed due to a temperature increase.

The plate 120 has the second opening parts OP2 arranged substantially uniformly in a plate plane. The second opening parts OP2 each have a smaller diameter than the first opening parts OP1. Therefore, the gas from the first opening parts OP1 temporarily remains in the gap GP and is thereafter substantially uniformly introduced into the temperature increase suppression region Rc through the second opening parts OP2. In this way, the plate 120 has a gas rectifying effect due to the second opening parts OP2.

The plate 120 includes partitions 121a, 121b, and 121c protruded on an opposed face F120 that is opposed to the gas supplier 40. As described later, the partitions 121a, 121b, and 121c are provided concentrically in a substantially circular manner in the opposed face F120 of the plate 120.

The opening part OP10 provided on the gas supplier 40 is a hole formed to supply the purge gas. As described above, the purge gas supplied from the opening part OP10 flows along the inner circumferential side surface of the liner 110 through the gap GP2 between the plate 120 and the liner 110. This operation enables the source gas introduced from the second opening parts OP2 into the temperature increase suppression region Rc to be less likely to reach the liner 110 and suppresses generation of reaction by-products on the surface of the liner 110.

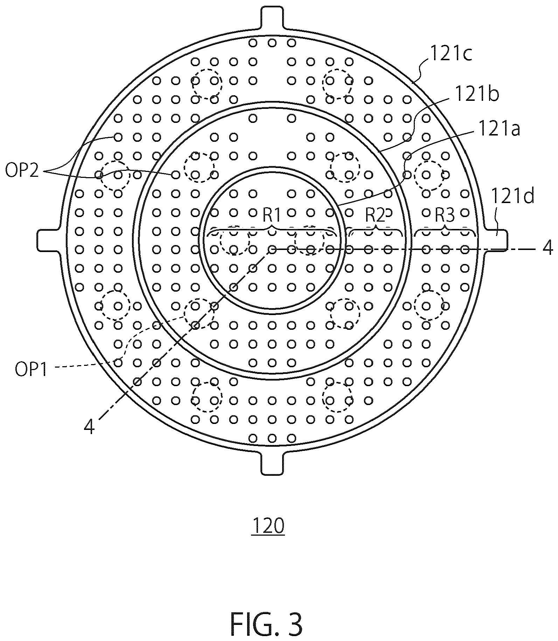

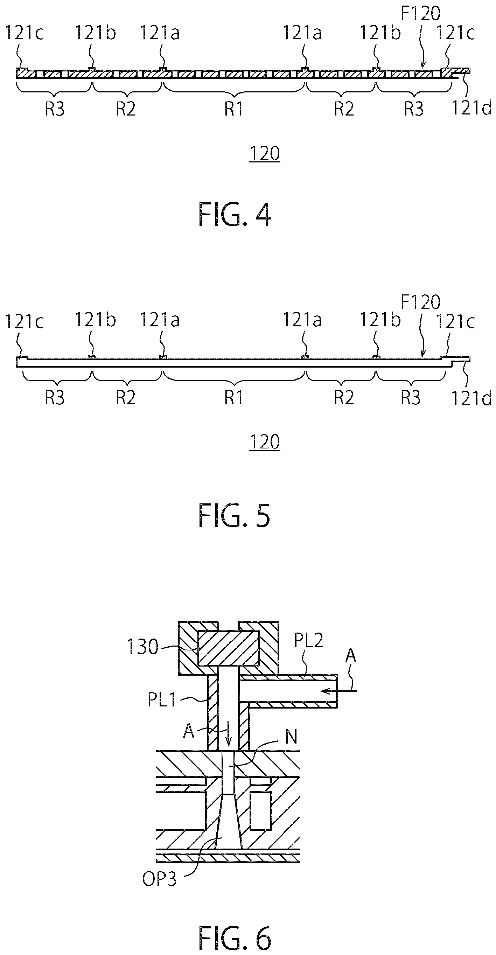

FIG. 3 is a diagram illustrating an arrangement relation between the plate 120 and the first opening parts OP1. FIG. 4 is a sectional view along a line 4-4 in FIG. 3. FIG. 5 is a side view of the plate 120. The configuration of the plate 120 and arrangement of the first opening parts OP1 are explained with reference to FIGS. 3 to 5.

The plate 120 has the partitions 121a, 121b, and 121c on the opposed face F120. A central region enclosed by the first partition 121a, which is located on the innermost circumference side among the partitions 121a, 121b, and 121c, is a first plate region R1. An intermediate region between the second partition 121b located on the outer circumference side of the first partition 121a and the first partition 121a is a second plate region R2. An outer region between the third partition 121c located on the outer circumference side of the second partition 121b and the second partition 121b is a third plate region R3.

The second opening parts OP2 are arranged substantially uniformly in the plate plane and substantially uniformly introduce the gas supplied to each of the regions R1 to R3 into the chamber 10. The first opening parts OP1 facing the first plate region R1 are denoted by OP1_1, the first opening parts OP1 facing the second plate region R2 are denoted by OP1_2, and the first opening parts OP1 facing the third plate region R3 are denoted by OP1_3. The opening parts OP1_1 to OP1_3 supply the gas to the regions R1 to R3 separated by the partitions 121a to 121c, respectively. The nozzles N of the openings parts OP1_1 to OP1_3 supply gases of concentrations different from each other or gases of types (compositions) different from each other, respectively, to the gap GP between the gas supplier 40 and the plate 120. Therefore, with the partitions 121a to 121c, the gasses supplied to the regions R1 to R3 are introduced into the chamber 10 through the second opening parts OP2 while being little mixed with each other in the gap GP.

The gas supplier 40 supplies the source gas (for example, silane gas, propane gas, or the like), the doping gas (for example, nitrogen gas, TMA (Trimethylaluminium) gas, diborane, or the like), the assist gas (HCl gas, or the like), the carrier gas (for example, hydrogen gas, argon gas, or the like) from the nozzles N.

The gas supplier 40 can change the ratio among the source gas, the doping gas, the assist gas, and the carrier gas, or the concentrations thereof in the regions R1 to R3. For example, the gas supplier 40 can change the ratio (C/Si ratio) between the silicon amount of silane in the source gas and the carbon amount in the propane gas in the regions R1 to R3. The gas supplier 40 also can change the flow rate of hydrogen gas as the carrier gas in the regions R1 to R3. Accordingly, the film thickness of the SiC film or the doping concentration in the plane of the substrate W can be adjusted to be substantially uniform.

In this way, the gas supplier 40 can supply the gases different in the concentration ratio to the regions R1 to R3, respectively. Since the plate 120 has the partitions 121a to 121c, the gasses supplied to the gaps GP in the regions R1 to R3 are prevented from being mixed and are substantially uniformly introduced into the chamber 10 from the second opening parts OP2, respectively.

While having the second opening parts OP2 to be opposed to the first opening parts OP1_1 to OP1_3 of the gas supplier 40, the plate 120 according to the present embodiment have no opening parts larger than the second opening parts OP2. Therefore, the gasses supplied from the first opening parts OP1_1 to OP1_3 temporarily remain in the associated gaps GP of the regions R1 to R3 and are then introduced into the chamber 10 through the second opening parts OP2 without being directly introduced into the chamber 10. Therefore, the plate 120 can substantially uniformly introduce the gas from each of the regions R1 to R3 into the chamber 10.

The gas supplier 40 has third opening parts OP3 as illustrated in FIG. 6. The third opening parts OP3 are pyro light paths for measuring the internal temperature of the chamber 10 by a radiation thermometer (not illustrated). The radiation thermometer measures the surface temperature of the substrate W through a nozzle to which a temperature measuring window is attached. For example, FIG. 6 is a sectional view illustrating a configuration example of the gas supplier 40 that includes nozzles N each having a temperature measuring window 130 attached thereto. The temperature measuring window 130 is attached to the third opening part OP3 of each of the nozzles N via a pipe PL1. The radiation thermometer measures the surface temperature of the substrate W in the chamber 10 through the pipe PL1. The pipe PL1 is communicated with a pipe PL2 separately from the temperature measuring window 130 and enables a gas (for example, hydrogen, argon, or the like) to flow as indicated by an arrow A. In the example illustrated in FIG. 3, the temperature measuring window 130 is provided to the third opening part OP3 in each of the regions R1 to R3.

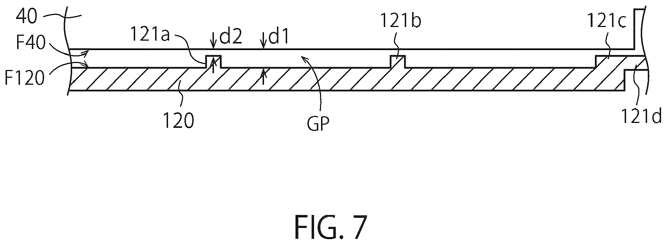

FIG. 7 is an enlarged view illustrating the gap GP between the gas supplier 40 and the plate 120. A first distance between the bottom face (a gas supply face) F40 of the gas supplier 40 and the top face (an opposed face) F120 of the plate 120 is denoted by d1 and a second distance between the bottom face F40 and the partitions 121a to 121c is denoted by d2. The second distance d2 is smaller than the first distance d1.

For example, it is desirable that the first distance d1 is about between 1.0 mm (millimeter) and 8.0 mm and the second distance d2 is about between 0.5 mm and 2 mm. If the first distance d1 is smaller than 1.0 mm, the gas separation effect with the partitions 121a to 121c is less likely to be obtained. If the first distance d1 is larger than 8.0 mm, the radiation effect from the plate 120 to the gas supplier 40 is reduced. If the second distance d2 is smaller than 0.5 mm, there is a risk that a part of the partitions 121a to 121c interferes with the gas supplier 40 due to deformation of the plate 120 because of a temperature increase. On the other hand, if the second distance d2 is larger than 2.0 mm, the partitions 121a to 121c cannot separate the gases in the regions R1 to R3 from each other. It is desirable that the ratio (d2/d1) between d1 and d2 is equal to or lower than 0.5. If d2/d1 is larger than 0.5, the gas separation effect is less likely to be obtained.

The diameter of the second opening parts OP2 on the plate 120 is, for example, not smaller than 0.5 mm and not larger than 5 mm. The total area of the second opening parts OP2 provided on the plate 120 is not less than 5% and not more than 25% with respect to the area of the face F120 of the plate 120 or the opposite face. If the diameter of each of the second opening parts OP2 is smaller than 0.5 mm, the gas flow from the plate 120 into the chamber 10 is deteriorated and the gas is likely to remain in the gap GP. Accordingly, the gas separation effect in the regions R1 to R3 separated by the partitions 121a to 121c is less likely to be obtained. If the diameter of each of the second opening parts OP2 is larger than 5 mm, the plate 120 ununiformly passes the gas depending on the positions of the first opening parts OP1 and therefore the gas rectifying effect is less likely to be obtained. If the total area of the second opening parts OP2 is less than 5% with respect to the area of the face F120 of the plate 120 or the opposite face, the gas flow deteriorates and therefore the gas is likely to remain in the gap GP. Accordingly, the gas separating effect in the regions R1 to R3 is less likely to be obtained. On the other hand, if the total area of the second opening parts OP2 is larger than 25% with respect to the area of the face F120 of the plate 120 or the opposite face, the plate 120 ununiformly passes the gas depending on the positions of the first opening parts OP1 and therefore the rectifying effect with the plate 120 is less likely to be obtained. Furthermore, the second opening parts OP2 are more likely to deform due to heat.

With the configuration described above, the film forming apparatus 1 according to the present embodiment can change the gas concentrations or the flow rates in the regions R1 to R3 while preventing mixture of the gas in the gap GP using the partitions 121a to 121c. As a result, uniformity in the film quality (the film thickness, the doping concentration, the mixed crystal composition ratio, the crystallinity, and the like) of a film formed on the substrate W can be enhanced.

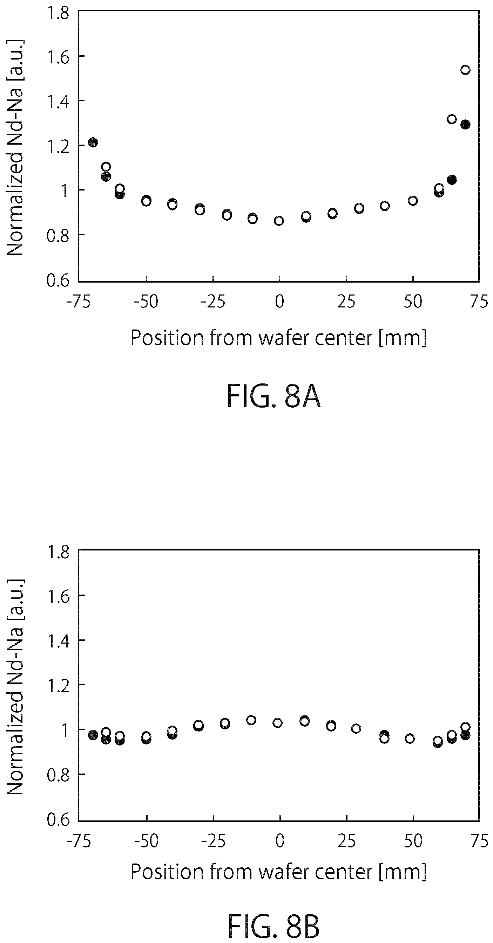

FIGS. 8A and 8B are graphs representing in-film doping concentration distributions in the plane of the substrate W. FIGS. 8A and 8B represent variations of the doping concentration when the ratio (C/Si ratio) between the silicon amount of silane in the source gas and the carbon amount of propane gas is changed in the regions R1 to R3. The vertical axes represent the doping concentration (normalized with an average value) in a formed film (for example, a SiC film). The horizontal axes represent the distance from the center of the substrate W, which is assumed to be zero (0).

In FIG. 8A, the gas supplier 40 sets the C/Si ratio of the gas to be 5.7 in the first plate region R1, 1.3 in the second plate region R2, and 1.0 in the third plate region R3, i.e., gradually decreases the C/Si ratio from the center of the substrate W toward the end portion. This setting causes the in-film doping concentration distribution in the plane of the substrate W to be relatively low at the center of the substrate W and relatively high at the end portion. That is, the doping concentration is substantially U-shaped in the plane of the substrate W.

In contrast thereto, in FIG. 8B, the gas supplier 40 sets the C/Si ratio of the gas to be 1.9 in the first plate region R1, 0.18 in the second plate region R2, and 4.3 in the third plate region R3, i.e., decreases once and then increases the C/Si ratio from the central portion toward the end portion. This setting flattens the in-film doping concentration distribution relative to that illustrated in FIG. 8A and it is understood that the in-plane uniformity of the doping concentration is improved.

As described above, the film forming apparatus 1 according to the present embodiment can control the distribution profile of the doping concentration in a film formed on the substrate W by adjusting the C/Si ratio of the gas from the center of the gas supplier 40 toward the outer circumference direction. That is, the in-plane uniformity of the doping concentration in a film formed on the substrate W can be improved.

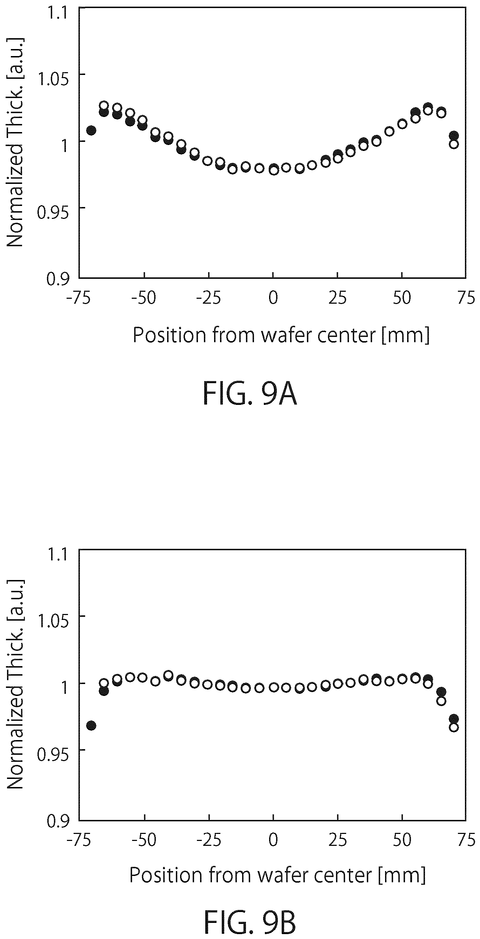

FIGS. 9A and 9B are graphs representing variations of the film thickness when the flow rate of hydrogen gas as the carrier gas is changed in the regions R1 to R3. The vertical axes in FIGS. 9A and 9B represent the film thickness (normalized with an average value) of a formed film (for example, a SiC film). The horizontal axes represent the distance from the center of the substrate W, which is assumed to be zero (0).

In FIG. 9A, the gas supplier 40 sets the flow rate of hydrogen gas to be 20 liters (L) in the first plate region R1, 62 L in the second plate region R2, and 70 L in the third plate region R3, i.e., gradually increases the flow rate from the center of the substrate W toward the end portion. This setting causes the film thickness to be relatively thin at the center of the substrate W and thicker at the end portion. That is, the doping concentration is substantially M-shaped in the plane of the substrate W.

In contrast thereto, in FIG. 9B, the gas supplier 40 sets the flow rate of hydrogen gas to be 13.5 L in the first plate region R1, 34.5 L in the second plate region R2, and 104 L in the third plate region R3, i.e., steeply increases the flow rate from the center of the substrate W toward the end portion. Accordingly, the film thickness is substantially uniformed from the center of the substrate W to the end portion while being thinned at the farthest end portion.

As described above, the film forming apparatus 1 according to the present embodiment can control the distribution profile of the film thickness of a film formed on the substrate W by adjusting the flow rate of hydrogen gas. That is, the in-plane uniformity of the film thickness of a film formed on the substrate W can be improved.

### (Second embodiment)

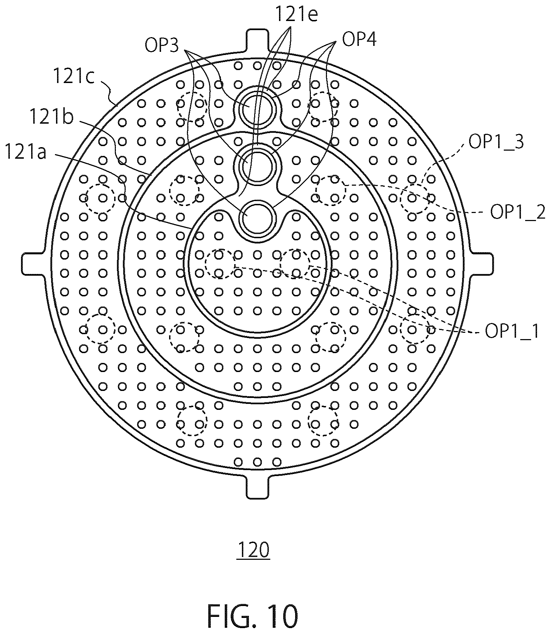

FIG. 10 is a diagram illustrating an arrangement relation between the plate 120 and the first opening parts OP1 according to a second embodiment. In the second embodiment, the plate 120 has fourth opening parts OP4 at positions corresponding to the third opening parts (pyro light paths) OP3 explained with reference to FIG. 6. The diameter of the fourth opening parts OP4 is preferably the same as or larger than that of the third opening parts OP3. The fourth opening parts OP4 can pass hydrogen gas from the third opening parts OP3 into the chamber 10 without supplying the hydrogen gas to the gap GP between the plate 120 and the gas supplier 40. The third opening parts OP3 are not blocked by the plate 120. Therefore, the radiation thermometer can accurately measure the temperature of the substrate W through the third opening parts OP3.

The plate 120 has a partition 121e all around each of the fourth opening parts OP4. Each of the partitions 121e is continuous with any of the partitions 121a to 121c and individually surrounds each of the fourth opening parts OP4. Therefore, the hydrogen gas from the third opening parts OP3 can be prevented from entering the gap GP between the plate 120 and the gas supplier 40. Accordingly, the film forming apparatus 1 can easily control the flow rate of the hydrogen gas in each of the regions R1 to R3.

### (Third embodiment)

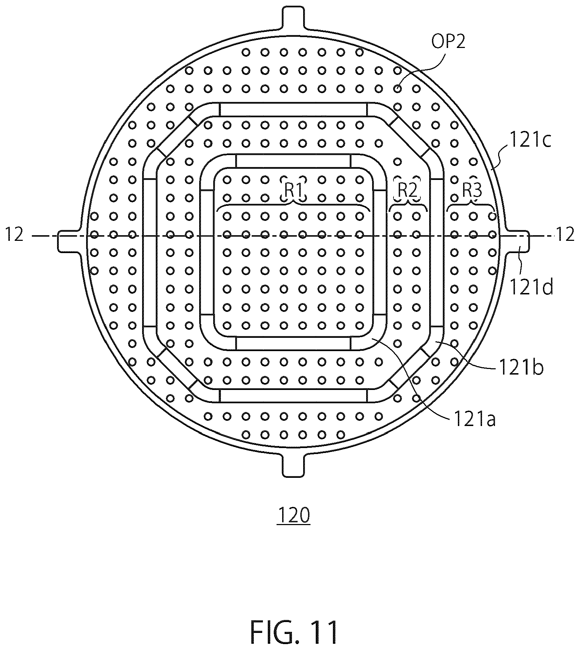

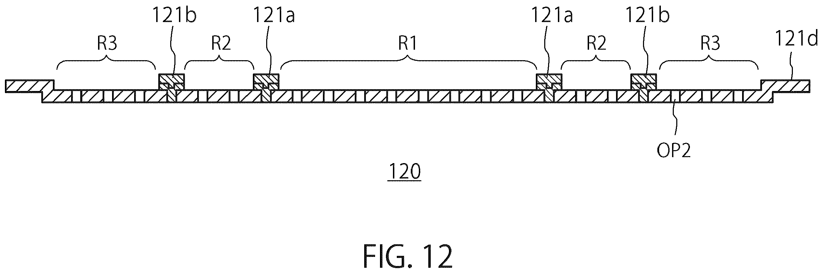

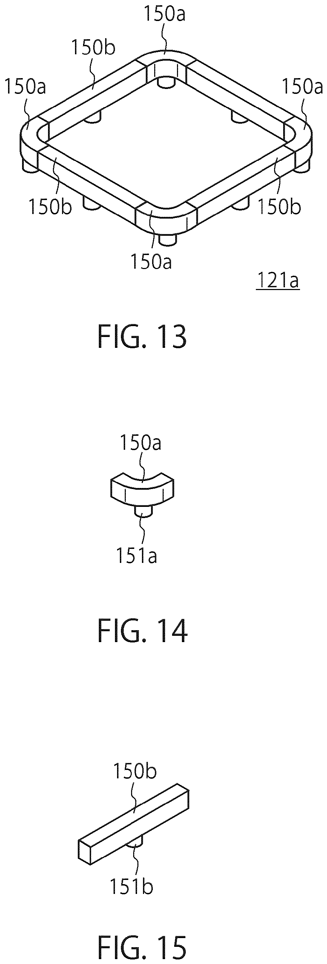

FIG. 11 is a diagram illustrating a configuration example of the plate 120 according to a third embodiment. FIG. 12 is a sectional view along a line 12-12 in FIG. 11. According to the third embodiment, each of the partitions 121a and 121b is constituted of a plurality of detachable jigs (for example, 150a and 150b in FIG. 13). The partitions 121a and 121b each may be any of a substantial square, a substantial circle, a substantial ellipse, and a substantial polygon in a planar layout seen from the direction of gas supply to the plate 120. The partitions 121 and 121b each can be constituted in any planar shape on the plate 120 by combining the jigs 150a and 150b, and the like. In this way, in the third embodiment, the partitions 121a and 121b are provided as separate members from the plate 120 and can separate the plate regions R1 to R3 in any manner by combination of the jigs 150a and 150b, and the like. The same material (for example, quartz) as that of the plate 120 can be used for the jigs 150a and 150b constituting the partitions 121a and 121b. Each of the partitions 121a and 121b may be integrally formed. Alternatively, each of the partitions 121a and 121b may be divided into a lower portion and an upper portion as illustrated in FIG. 12. In this case, each of the partitions 121a and 121b is constituted by connecting the lower portion and the upper portion to each other.

FIG. 13 is a perspective view illustrating a configuration example of the partition 121a. FIG. 14 is a perspective view illustrating a configuration example of the jig 150a. FIG. 15 is a perspective view illustrating a configuration example of the jig 150b. The partition 121a is constituted of the jigs 150a and 150b having different shapes from each other. The partition 121a has a substantially quadrangular shape with four rounded corners by combination of four jigs 150a and four jigs 150b.

Each of the jigs 150a is formed by bending a rectangular column member and has a protrusion 151a as illustrated in FIG. 14. The protrusion 151a has a planar shape substantially similar to that of the opening parts OP2 illustrated in FIG. 12 to be fitted into the opening parts OP2, and is formed to be slightly smaller than the opening parts OP2 in the planar shape. The length of the jigs 150a in the horizontally extending direction and the length thereof in the vertically extending direction can be freely set. While the jigs 150a are bent at 90 degrees to form the substantially quadrangular shape with the four rounded corners in FIG. 14, the corners may be formed by bending at any angle in order to form a freely-selected shape.

Each of the jigs 150b is formed of a rectangular column member and has a protrusion 151b as illustrated in FIG. 15. The protrusion 151b has a planar shape substantially similar to that of the opening parts OP2 to be fitted into the opening parts OP2, and is formed to be slightly smaller than the opening parts OP2 in the planar shape, similarly to the protrusion 151a. The length of the jigs 150b in the horizontally extending direction and the length thereof in the vertically extending direction can be freely set.

The jigs 150a and 150b are fixed on the surface of the plate 120 by fitting the protrusions 151a and 151b of the jigs 150a and 150b into the opening parts OP2, respectively, whereby the partition 121a can be constituted.

As in the above explanations of the partitions 121a and 121b, each of the jigs 150a and 150b may be integrally formed. Alternatively, each of the jigs 150a may be divided into a lower portion of the protrusion 151a and an upper portion located thereabove. Each of the jigs 150b may be divided into a lower portion of the protrusion 151b and an upper portion located thereabove. In this case, each of the jigs 150a and 150b is constituted by connecting the lower portion and the upper portion to each other.

The configuration of the partition 121a has been explained above. The shape of the partition 121a in the planar layout seen from the direction of gas supply to the plate 120 can be changed by combining the jigs 150a and 150b or other jigs different in the shape or size from the jigs 150a and 150b. The shape of the partition 121b in the planar layout seen from the direction of gas supply to the plate 120 also can be freely constituted by combining the jigs 150a and 150b or other jigs different in the shape or size from the jigs 150a and 150b.

The rest of the configuration of the third embodiment may be identical to the corresponding one of the first embodiment. Therefore, as illustrated in FIGS. 11 and 12, the partitions 121a and 121b are protruded from the surface of the plate 120 and separate the plate 120 into the plate regions R1 to R3. The second distance d2 between the bottom face F40 and the partitions 121a and 121b as illustrated in FIG. 7 can be adjusted by changing the sizes of the jigs 150a and 150b. With this configuration, the third embodiment can obtain effects identical to those in the first embodiment.

### (Modification)

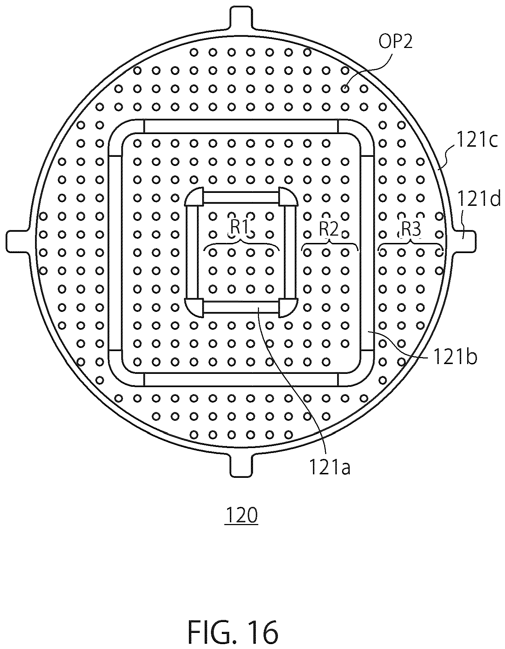

FIG. 16 is a diagram illustrating a configuration example of the plate 120 according to a modification of the third embodiment. According to the present modification, the planar shapes of the partitions 121a and 121b are different from those illustrated in FIG. 11 in the planar layout seen from the direction of the gas supply to the plate 120. The rest of the configuration of the present modification can be identical to that in the third embodiment. In this way, the planar shapes of the partitions 121a and 121b can be freely changed by the shapes of jigs and combination thereof. The number of partitions may be three or more. The plate regions can be more finely divided by increasing the number of partitions. The present modification can obtain effects identical to those in the third embodiment.

While certain embodiments of the present invention have been described, these embodiments have been presented by way of example only, and are not intended to limit the scope of the invention. The novel embodiments described herein may be embodied in a variety of other forms, and various omissions, substitutions, and changes may be made without departing from the spirit of the invention. These embodiments and modifications thereof would fall within the scope and spirit of the invention, and would fall within the invention described in the accompanying claims and their equivalents.

## Claims

1. A film forming apparatus comprising:
a film formation chamber capable of accommodating a su bstrate;
a gas supplier comprising a plurality of nozzles provided in an upper portion of the film formation chamber to supply a process gas onto a film formation face of the substrate, and a cooling part configured to suppress a temperature increase of the process gas;
a heater configured to heat the substrate to 1500°C or higher; and
a plate opposed to a bottom face of the gas supplier, where first opening parts of the nozzles are formed, in the film formation chamber, and arranged away from the bottom face, wherein
the plate comprises
a plurality of second opening parts having a smaller diameter than the first opening parts, and arranged substantially uniformly in a plane of the plate, and
a partition protruded on an opposed face to the gas supplier and separating the plane of the plate into a plurality of regions.

2. The film forming apparatus of Claim 1, wherein
the plate comprises a first plate region enclosed by the partition, and a second plate region on an outer circumference side of the partition, and
a process gas is supplied from the gas supplier to the first plate region and the second plate region at concentrations different from each other or flow rates different from each other.

3. The film forming apparatus of Claim 1, wherein a plurality of the partitions are provided concentrically on the opposed face.

4. The film forming apparatus of Claim 1, wherein
the gas supplier comprises a third opening part for measuring an internal temperature of the film formation chamber, and
the plate comprises a fourth opening part same as or larger than the third opening part at a location facing the third opening part, and the partition is further provided around the fourth opening part.

5. The film forming apparatus of Claim 4, wherein the partition is provided around the fourth opening part.

6. The film forming apparatus of Claim 1, wherein the second opening parts are provided also at opposed locations of the plate opposed by the nozzles.

7. The film forming apparatus of Claim 1, wherein
a gap between the gas supplier and the plate is between 1.0 mm and 8.0 mm, and
a gap between the gas supplier and the partition is between 0.5 mm and 2 mm.

8. The film forming apparatus of Claim 1, wherein a diameter of the second opening parts is between 0.5 mm and 5 mm.

9. The film forming apparatus of Claim 1, wherein the partition is removably attached to the plate.

10. The film forming apparatus of Claim 9, wherein the partition comprises a protrusion to be fitted into the second opening parts.

11. A plate opposed to a gas supplier configured to supply a gas onto a film formation face of a substrate in a film formation chamber, the plate being placed away from the gas supplier, the plate comprising:
a plurality of second opening parts having a smaller diameter than first opening parts of nozzles provided on the gas supplier to supply the gas, the second opening parts being arranged substantially uniformly in a plane of the plate; and
a partition protruded on an opposed face to the gas supplier.

12. The plate of Claim 11, comprising a first plate region enclosed by the partition, and a second plate region on an outer circumference side of the partition.

13. The plate of Claim 11, wherein a plurality of the partitions are provided concentrically on the opposed face.

14. The plate of Claim 11, wherein
the gas supplier comprises a third opening part for measuring an internal temperature of the film formation chamber, and
the plate comprises a fourth opening part same as or larger than the third opening part at a location facing the third opening part, and the partition is further provided around the fourth opening part.

15. The plate of Claim 11, wherein the second opening parts are provided also at opposed locations of the plate opposed by the nozzles.

16. The plate of Claim 11, wherein the partition is removably attached to the plate.

17. The plate of Claim 16, wherein the partition comprises a protrusion to be fitted into the second opening parts.
